# EUROPÄISCHE PATENTSCHRIFT

(11) **EP 0 973 205 B1**
(45) Veröffentlichungstag und Bekanntmachung des Hinweises auf die Patenterteilung: **19.05.2004**
(21) Anmeldenummer: 99112317.5
(22) Anmeldetag: 26.06.1999
(51) Int. Cl.: H01L 29/78, H01L 21/336, H01L 21/266, H01L 29/10, H01L 21/8234

(54) **Hochspannungs-MOS-Transistor**
High voltage MOS transistor
Transistor de type MOS haute tension

(30) Priorität: 26.06.1998 DE 19828520
(43) Veröffentlichungstag der Anmeldung: 19.01.2000
(73) Patentinhaber: ELMOS Semiconductor AG, 44227 Dortmund (DE)
(72) Erfinder: Giebel, Thomas, Dr., 44139 Dortmund (DE)
(74) Vertreter: Hilleringmann, Jochen, Dipl.-Ing.

(56) Entgegenhaltungen:
- WO-A-97/13277
- US-A- 4 172 260
- US-A- 4 933 730
- PATENT ABSTRACTS OF JAPAN vol. 1995, no. 04, 31. Mai 1995 (1995-05-31) & JP 07 030107 A (SONY CORP), 31. Januar 1995 (1995-01-31)

## Beschreibung

Die Erfindung betrifft einen MOS-Transistor mit hoher Spannungsfestigkeit und geringem Einschaltwiderstand. Insbesondere betrifft die Erfindung einen PMOS-Transistor, der über eine hohe Spannungsfestigkeit bei geringem Einschaltwiderstand verfügt.

Ein Hochvolt-PMOS-Transistor mit einer Durchbruchspannung von ca. 44 V ist in EP-A-91 911 911 (Veröffentlichungsnummer EP 0 536 227 B1) beschrieben. Gerade im Automotive-Bereich werden jedoch erhöhte Anforderungen an die Durchbruchspannungsfestigkeit gestellt. So ist es beispielsweise wünschenswert, wenn ein PMOS-Transistor eine Spannungsfestigkeit von > 60 V, vorzugsweise ca. 80 V aufweist, wobei zusätzlich gefordert wird, daß der Einschaltwiderstand dieses Transistors relativ gering ist.

Die Spannungsfestigkeit von MOS-Transistoren setzt voraus, daß das elektrische Feld zwischen der drainseitigen Gate-Kante und dem Drain abgebaut und die Stärke des elektrischen Feldes an der drainseitigen Gate-Kante verringert wird. Dies läßt sich prinzipiell dadurch erreichen, daß das Drain von der drainseitigen Gate-Kante beabstandet wird und zwischen dem Draingebiet und dem Gate ein sogenanntes Drainextension-Gebiet angeordnet wird., das eine geringere Konzentration an Ladungsträgern aufweist. Das Drainextension-Gebiet erstreckt sich dabei um das Draingebiet herum, so daß letzteres innerhalb des ersteren angeordnet wird.

Mit einem derartigen Drainextension-Gebiet läßt sich aufgrund der relativ niedrigen Konzentration an Ladungsträgern das elektrische Feld zwischen Drain und drainseitiger Gate-Kante ausreichend stark abbauen und die Stärke des elektrischen Feldes an der Gate-Kante in ausreichendem Maße verringern. Allerdings steigt bei einem derartigen Transistor-Design der Einschaltwiderstand an. Dieser Einschaltwiderstand kann abgesenkt werden, wenn es gelingt, die Ladungsträgerkonzentration im Drainextension-Gebiet ausgehend von der drainseitigen Gate-Kante bis zum Drain-Gebiet allmählich zu erhöhen. Ein Beispiel für einen derartigen MOS-Transistor mit lateral moduliertem Drainextension-Gebiet ist aus WO-A-97/13277 bekannt. Dort wird die Laterialmodulation der Dotierstoffkonzentration im Drainextension-Gebiet durch Einbringen einer n-Ionenimplantation unter Ausmaskierung mindestens eines Abstandsbereichs erzielt, wobei die nach der Ionenimplantation getrennten Implantationsgebiete durch anschließende thermisch induzierte Diffusion "ineinanderlaufen". In diesen Bereichen ist dann die Dotierstoffkonzentration verringert.

Steht allerdings für die Ausbildung des Drainextension-Gebiets lediglich eine Ionenimplantation ohne anschließende thermisch induzierte Diffusion zur Verfügung, so kann man gemäß den in der zuvor genannten PCT-Veröffentlichung angegebenen Maßnahmen nicht verfahren, um eine Lateralmodulation im ionenimplantierten Drainextension-Gebiet zu realisieren. Eine Alternative bestünde darin, das Drainextension-Gebiet durch Einbringen mehrerer Ionenimplantationen mit unterschiedlicher Energie aufzubauen. Dies allerdings erfordert zusätzliche Prozeßschritte, was insoweit nachteilig ist.

Der Erfindung liegt die Aufgabe zugrunde, einen MOS-Transistor mit hoher Spannungsfestigkeit und geringem Einschaltwiderstand zu schaffen, dessen Drainextension-Gebiet ionenimplantiert ist, wobei der Ionenimplantationsschritt zur Erzeugung des Drainextension-Gebiets unverändert bleiben soll.

Zur Lösung dieser Aufgabe wird mit der Erfindung ein MOS-Transistor gemäß Ansprüch 1 vorgeschlagen.

Bei dem erfindungsgemäßen MOS-Transistor wird zur Erhöhung der Spannungsfestigkeit auf einen klassischen Ansatz zurückgegriffen, indem unter der drainseitigen Gate-Kante ein Feldoxidsteg angeordnet wird. Da die Ionenimplantation für das Drainextension-Gebiet nach der Ausbildung dieses Feldoxidstegs eingebracht wird, weist das Drainextension-Gebiet unterhalb des Feldoxidstegs eine geringere Tiefe auf als im übrigen Bereich; denn nur der höher energetische Anteil der Ionenimplantation für das Drainextension-Gebiet kann den Feldoxidsteg durchdringen. Damit bildet sich ein relativ schmaler Kanalanbindungsbereich unter dem Feldoxidsteg auf, über den der gesamte vom Gate zum Drain fließende Strom abgeführt wird. Die Besonderheit des erfindungsgemäßen MOS-Transistors ist darin zu sehen, daß es gelungen ist, die Dotierstoffkonzentration unterhalb des Feldoxidstegs und in dem Bereich zwischen dem Feldoxidsteg und dem Drain-Gebiet innerhalb des Drainextension-Gebiets zu erhöhen, ohne die Ionenimplantation zur Herstellung des Drainextension-Gebiets zu verändern. Dies gelingt bei dem erfindungsgemäßen MOS-Transistor durch eine Lateralmodulation der Dotierstoffkonzentration innerhalb des Wannengebiets. Dieses Wannengebiet ist nämlich bei dem erfmdungsgemäßen MOS-Transistor durch Implantation zweier Teilgebiete erzeugt, die um einen Abstandsbereich voneinander beabstandet sind. Dieser Abstandsbereich entspricht bezüglich seiner Lage demjenigen Bereich, in dem der Feldoxidsteg und der Abstandsbereich zwischen Feldoxidsteg und Drain-Gebiet angeordnet ist. Nach der Ausdiffusion der beiden voneinander getrennten ionenimplantierten Teilbereiche des Wannengebiets entsteht ein durchgehendes Wannengebiet, dessen Dotierstoffkonzentration in dem dem Abstandsbereich entsprechenden Verbindungsbereich der beiden Teilgebiete verringert ist. Diese Dotierstoffkonzentrationsverringerung bringt dann, wenn die Ionenimplantation für das Drainextension-Gebiet eingebracht ist, eine erhöhte Konzentration an elektrisch aktiver Dotierung innerhalb des Drainextension-Gebiets mit sich.

Durch die zuvor beschriebenen Maßnahmen weist der erfindungsgemäße MOS-Transistor in seinem zwischen dem drainseitigen Endbereich des Gates und dem Drain-Gebiet angeordneten Bereich seines Drainextension-Gebiets zwei Teilbereiche mit unterschiedlicher Dotierstoffkonzentration auf Der erste Teilbereich ist dabei unterhalb des Feldoxidstegs angeordnet, während der zweite Teilbereich zwischen diesem ersten Teilbereich und dem Drain-Gebiet angeordnet ist bzw. das Drain-Gebiet zumindest bis in diesen zweiten Teilbereich hineinragt. Im ersten Teilbereich ist die Konzentration an elektrisch aktiver Dotierung kleiner als im zweiten Teilbereich. Dies hat seine Ursache darin, daß der erste Teilbereich bei der Ionenimplantation für das Drainextension-Gebiet von dem Feldoxidsteg überdeckt ist und demzufolge im ersten Teilbereich lediglich ein geringerer Anteil an Ionenimplantation als im zweiten Teilbereich eingebracht werden kann. Allerdings ist die Konzentration an elektrisch aktiver Dotierung im ersten Teilbereich größer als im übrigen Drainextension-Gebiet, mit Ausnahme des zweiten Teilbereichs. Dies wiederum ist darin begründet, daß die Dotierstoffkonzentration des Wannengebiet in dem den beiden Teilbereichen des Drainextension-Gebiets entsprechenden Bereich durch die Ausmaskierung (Abstandsbereich) abgesenkt ist. Insgesamt ergibt sich damit innerhalb der beiden Teilbereiche des Drainextension-Gebiets eine Dotierstoffkonzentrationsmodulation sowohl in vertikaler als auch in lateraler Richtung. Insbesondere stellt sich unterhalb des Feldoxidstegs ein Bereich des Drainextension-Gebiets ein, der über eine erhöhte Konzentration an elektrisch aktiver Dotierung verfügt, was sich vorteilhaft auf den Einschaltwiderstand des MOS-Transistors auswirkt. Ebenfalls vorteilhaft für diesen Einschaltwiderstand wirkt sich der Umstand aus, daß der sich an den Feldoxidsteg anschließende zweite Teilbereich des Drainextension-Gebiets eine gegenüber dem ersten Teilbereich nochmals erhöhte Konzentration an elektrisch aktiver Dotierung einstellt.

Durch die Ausmaskierung des Wannengebiets wird also bei einem MOS-Transistor mit Feldoxidsteg unter dem drainseitigen Endbereich des Gates eine Vertikal- und Lateralmodulation der Konzentration an elektrisch aktiver Dotierung des Drainextension-Gebiets erreicht, ohne daß dieses mit einer lokal unterschiedliche Energien aufweisenden Ionenimplantation hergestellt werden muß. Vielmehr kann das Drainextension-Gebiet unter Zuhilfenahme einer über seine gesamte Fläche gleichbleibenden Ionenimplantation ausgebildet werden. Am Herstellungsprozeß muß daher nichts geändert werden, was die Drainextension-Ionenimplantation anbelangt. Es ist lediglich die Ausmaskierung des Wannengebiets bei Einbringung der Ionenimplantation hierfür erforderlich. Dies ist aber letztendlich ohne Auswirkungen auf den Herstellungsprozeß.

Wie bereits oben dargelegt, wird also bei dem erfmdungsgemäßen MOS-Transistor dem klassischen Ansatz zur Erhöhung der Spannungsfestigkeit gefolgt, der neben einer Driftstrecke (Drainextension) auch eine Feldplatte im drainseitigen Endbereich des Gates zur Entzerrung des elektrischen Feldes vorsieht.

Dies ist im Falle der implantierten Driftstrecke bzw. Drainextension nach der Feldoxidation, wie es nach der Erfindung vorgesehen ist, doppelt problematisch: zum einen muß der Kanal sicher angebunden werden, ohne daß die Dotierstoffkonzentration in diesem Bereich zu groß wird, zum anderen wird die Dotierstoffkonzentration unter dem Feldoxid der Feldplatte recht gering und damit der ON-Widerstand recht hoch sein.

Versuche hierzu zeigen, daß die Kanalanbindung prozeßtechnologisch unkritisch ist. Man kann sogar noch einige Volt Durchbruchspannung gewinnen, wenn die Implantation insbesondere 0,5 bis 1 µm in den Kanal hineinragt. Ursache ist hier, daß das elektrische Feld des pn-Überganges zwischen Drainextension und Wanne nicht mit der nach wie vor vorhandenen Feldspitze an Anfang der Feldplatte zusammenfallen sollte.

Schwieriger zu behandeln ist das Problem der hochohmigen Driftstrecke unter dem Feldoxidsteg. Versuche die Verluste im ON-Widerstand durch Verkürzung der Driftstrecke zwischen Feldoxidsteg und p+ Draingebiet zu kompensieren waren ohne Erfolg. Insgesamt gelang es bisher die Durchbruchspannung dieser Transistoren bis auf knapp 90 V zu erhöhen, wobei gegenüber den derzeit benutzten HVPMOS-Transistoren eine Zunahme des ON-Widerstandes von 30 - 50 % zu verzeichnen war.

Eine wichtige Verbesserung bringt die Herstellung eines Wannengebiets durch Ausmaskierung implantierter Teilgebiete und anschließende Zusammendiffussion dieser Teilgebiete. Wird die Wannen-Implantation (hier beschrieben anhand eines PMOS-Transistors in einer n-Wanne) im Bereich des Feldoxidsteges ausmaskiert, so sinkt nach der Nachdiffusion und Feldoxidation die Phosphorkonzentration in diesem Bereich. Dies gilt umso mehr, als in diesem Bereich die Phosphorkonzentration aufgrund der Segregation besonders hoch ist. Niedrige Phosphorkonzentration bedeutet aber gleichzeitig hohe elektrisch aktive Borkonzentration und damit höhere Leitfähigkeit. Simulationen hierzu haben ergeben, daß die Borkonzentration und damit der Strom durch den Transistor um bis zu 50 % erhöht werden können. Es soll allerdings nicht verschwiegen werden, daß damit auch die Borkonzentration im Überlappungbereich zwischen Kanal und Drainextension steigt und damit die Durchbruchspannung um 10 - 20 % sinkt. Dies ist bei einer maximalen Durchbruchspannung von 90 V und einer angestrebten Durchbruchspannung von 60 V tolerierbar.

Als Drainextension wird bei dem neuen PMOS-Transistor eine ein- oder zweiteilige p-Dotierungsimplantation eines LOCOS-Prozesses benutzt, die aber wegen des zu steilen Profils nicht ohne weiteres eingesetzt werden sollte. Das ausgeprägte Maximimum in diesem Profil verursacht eine Feldstärkespitze an der drainseitigen Gatekante, die zum vorzeitigen Durchbruch des herkömmlichen HV-PMOS führt. Um diese Feldstärkespitze zu entschärfen, wird der klassische Ansatz einer Feldplatte gewählt: Im Bereich der drainseitigen Gatekante wird ein Feldoxidsteg erzeugt, so daß die drainseitige Gatekante in der Mitte dieses Steges zu liegen kommt. Damit liegt die Feldstärkespitze nun im Feldoxid und hat keinen Einfluß mehr auf das Silizium. Da nun aber die p-Dotierungsimplantation erst nach der Feldoxidation erfolgen kann, ergibt sich ein Problem: Nur eine hochenergetische PDEX-Implantation kann das Feldoxid durchdringen und so nur eine dünne p-leitende Schicht im Silizium erzeugen. Damit ist die sichere Kanalanbindung gefährdet und das ganze Gebilde wird recht hochohmig.

Die Kanalanbindung wird dadurch gewährleistet, daß die p-Dotierungsimplantation bis in die Kanalregion hineinragt. Diese Überlappung sollte mindestens 0,5 µm bis ca. 1 µm betragen um sicherzustellen, daß der pn-Übergang zwischen Implantationsgebiet und Wanne einen ausreichenden Abstand von der Aktivgebietskante des Feldoxidsteges hat. Anderenfalls entsteht an dieser Kante wieder eine kritische Feldstärkespitze.

Zur Verringerung des ON-Widerstandes sollte der Feldoxidsteg so schmal wie technologisch möglich gemacht werden, um diesen hochohmigen Teil der Driftstrecke so kurz wie möglich zu halten. Dabei ist zu beachten, daß dadurch die Feldoxiddicke auch geringer wird, wodurch wiederum die Feldstärke steigt.

Besser wäre es, die elektrisch aktive Borkonzentration in diesem Bereich zu erhöhen, wobei aber weder Energie noch Dosis der p-Dotierungsimplantation verändert und kein zusätzlicher Diffusionsschritt eingeführt werden darf.

Da aber in diesem Bereich die elektrisch aktive Dotierung von zwei Dotierstoffen, Bor und Phosphor, bestimmt wird, eröffnet sich die Möglichkeit, die elektrisch aktive Borkonzentration durch Verringerung der Phosphorkonzentration zu erhöhen. Dazu wird die Wannen-Implantation im Bereich des Feldoxidsteges ausmaskiert. Durch die Nachdiffusion diffundieren die beiden Wannenteile wieder zusammen und man erreicht so eine verringerte Phoshorkonzentration in diesem Bereich. Vorteilhafterweise ist dann auch die Überhöhung der Phosphorkonzentration unter dem Feldoxid aufgrund der Segregation nicht mehr so hoch. Damit steigt in der sich anschließenden Bor-Implantation die elektrisch aktive Dotierung und damit die Leitfähigkeit der Driftstrecke unter dem Feldoxid um eben jenen Betrag, um den man die Phosphorkonzentration abgesenkt hat, ca. 30 - 50 %.

Letztlich sollte auch hier darauf geachtet werden, daß die p+ Drainimplantation von beiden Aktivgebietskanten einen Abstand hat, um Feldstärkespitzen an diesen Kanten zu vermeiden.

Die Abfolge eines Prozesses zur Herstellung eines als PMOS-Transistor ausgeführten erfindungsgemäßen Transistors ist z.B.:
- Ausgangsmaterial p-Silizium Epi
- Wannen-Implantation Phosphor mit Wannenspalt (Abstandsbereich zwischen den beiden implantierten Wannen-Teilgebieten)
- Nachdiffusion und Feldoxidation LOCOS (Feldoxidsteg)
- insbesondere zweiteilige p-Dotierungsimplantation (für die Driftstrecke/Drainextension)
- optional - Schwellen-Implantation PMOS mit Ausmaskierung an der späteren drainseitigen Gate-Kante
- Poly-Deposition und Gatestrukturierung
- p+ Implantation PMOS Drain/Source (drainseitig mit Abstand von Gate und Aktivgebietskante)
- Zwischenoxid
- Kontaktlöcher
- Metallisierung.

Nachfolgend wird die Erfindung anhand eines PMOS-Transistors unter Bezugnahme auf die Figuren näher erläutert. Im einzelnen zeigen:
- Fign. 1 bis 3: Querschnitte durch den oberflächennahen Bereich eines p-Substrats in verschiedenen Phasen des Herstellungsprozesses für einen spannungsfesten PMOS-Transistor mit geringem Einschaltwiderstand und
- Fign. 4 bis 6: Dotierstoffkonzentrationsverläufe an in den Fign. 2 und 3 näher bezeichneten Stellen des p-Substrats.

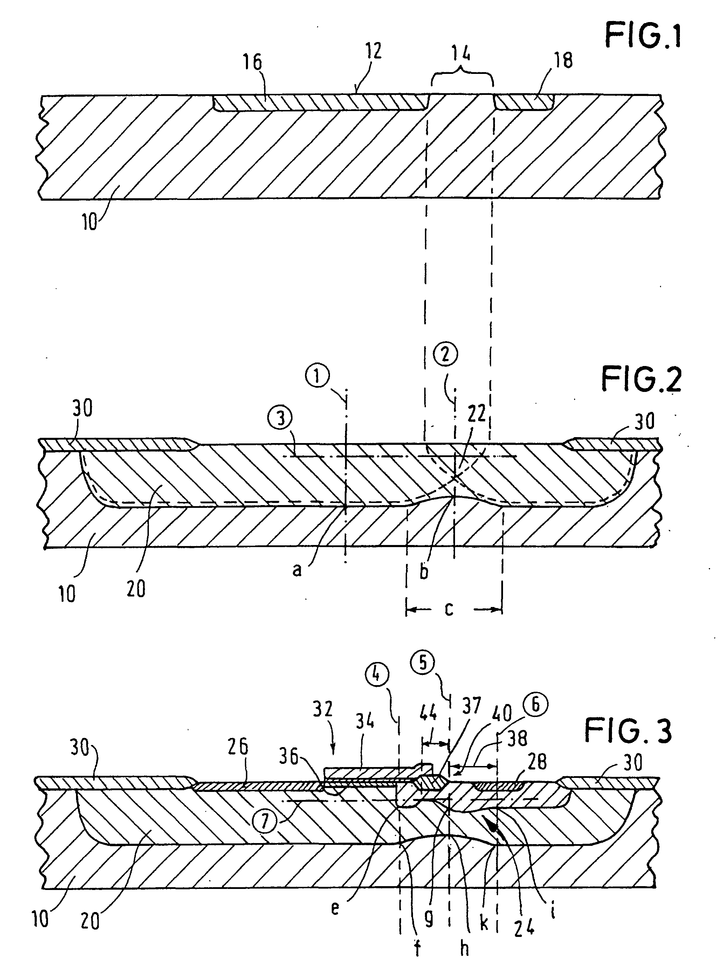

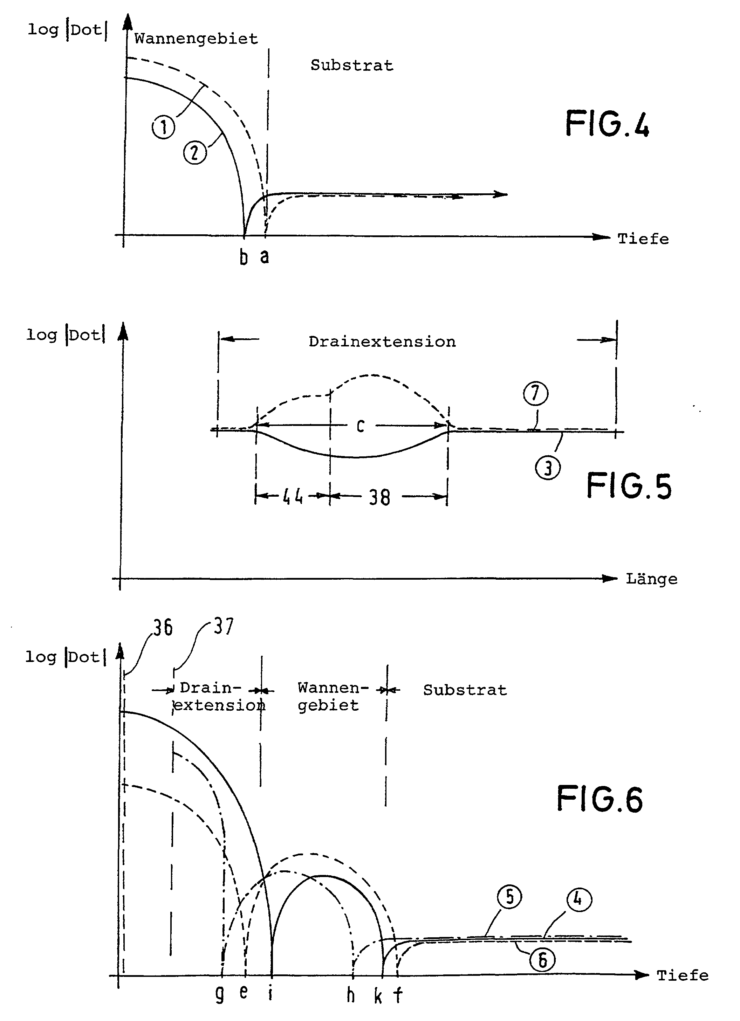

Fig. 1 zeigt ein p-Substrat 10, in dessen Oberfläche 12 zwei durch einen Abstandsbereich 14 voneinander beabstandete n-Ionenimplantationsgebiete 16,18 eingebracht sind. Diese beiden Gebiete 16,18 laufen bei der anschließenden thermisch induzierten Diffusion zum n-Wannengebiet 20 gemäß Fig. 2 zusammen. In dem dem Abstandsbereich 14 entsprechenden Verbindungsbereich 22 stellt sich dann zum einen eine verringerte Tiefe des n-Wannengebiets 20 und zum anderen eine verringerte Phosphor-Dotierstoffkonzentration ein. Dies ist anhand der beiden Kurven der Fig. 4 sowie anhand der Kurve 3 der Fig. 5 zu erkennen. In Fig. 4 ist mit der Kurve 1 das sich in Tiefenerstreckung der n-Wanne 20 außerhalb des Verbindungsbereichs 22 einstellende Dotierstoffkonzentrationsprofil als Betrag der Dotierstoffkonzentration dargestellt. Ausgehend von der Dotierstoffkonzentration an der Oberfläche 12 des p-Substrats 10 nimmt die Konzentration bis zum Grund des n-Wannengebiets 20 (pn-Übergang a der Fig. 2) ab, um dann mit zunehmender Tiefenerstreckung in das p-Substrat dessen Dotierstoffkonzentration anzunehmen.

Anders sieht die Situation im Falle der Kurve 2 der Fig. 4 aus. Von einem Dotierstoffkonzentrationswert an der Substrat-Oberfläche 12, der geringer ist als im Falle der Kurve 1, nimmt die Dotierstoffkonzentration bis zum pn-Übergang b, der oberhalb des pn-Übergangs a liegt, ab, um von dort aus mit zunehmender Tiefe in das p-Substrat 10 dessen Dotierstoffkonzentration anzunehmen.

In lateraler Richtung ergibt sich die Situation gemäß der Kurve 3 in Fig. 5. Im Verbindungsbereich 22 sowie beidseitig von diesem (bei c in Fign. 2 und 5 angedeutet), ergibt sich eine gegenüber dem übrigen Bereich des n-Wannengebiets 20 verringerte Dotierstoffkonzentration.

Fig. 3 zeigt die Situation nach Einbringung des Drainextension-Gebiets 24 und nach Ausbildung des Source-Gebiets 26 sowie des Drain-Gebiets 28, das innerhalb des Drainextension-Gebiets 24 angeordnet ist. Zum Zeitpunkt der Einbringung der Ionenimplantation für das Drainextension-Gebiet 24 sind bereits das Feldoxid 30 sowie vom Gate 32 dessen Gate-Oxid 36 mit Feldplatte 37 ausgebildet. Die Ausbildung dieser Oxidschichten erfolgt gleichzeitig mit der thermisch induzierten Diffusion des Wannengebiets 20. Die in Fig. 3 gezeigte Gate-Elektrode 34 ist zu diesem Zeitpunkt noch nicht ausgebildet, ist aber der Vollständigkeit halber in Fig. 3 mit eingezeichnet.

Wie in Fig. 3 gezeigt, entsprechen dem Bereich c des Wannengebiets 20 innerhalb des Drainextension-Gebiets 24 die beiden Teilgebiete 38 und 44. Das Teilgebiet 38 ist dabei um den Abstand 40 von der drainseitigen Gate-Kante 42 beabstandet, unterhalb derer die Feldplatte 37 angeordnet ist, die sich beidseitig dieser drainseitigen Gate-Kante 42 sowohl weiter unterhalb des Gate 32 sowie andererseits in Richtung des Drain-Gebiets 28 erstreckt. In diesem Teilgebiet 44, in dem sich der Feldoxidsteg 37 zumindest teilweise erstreckt, liegt eine niedrigere Konzentration an elektrisch aktiver Dotierung (Bor-Dotierung) im Drainextension-Gebiet 24 vor, als in dem sich zum Drain-Gebiet 28 hin erstreckenden anderen Teilgebiet 38. Die Ursache dafür besteht darin, daß wegen des Feldoxidstegs 37 bei der Ionenimplantation des Drainextension-Gebiets 24 weniger Dotierstoffe in den Bereich 44 als in den Bereich 38 gelangen und daß in dem beiden Teilgebieten 38 und 44 entsprechenden Bereich (c) des Wannengebiets 20 wegen der Ausmaskierung eine geringere Konzentration an Dotierstoffen (in diesem Fall Phosphorkonzentration) vorliegt. Da jedoch die Phosphorkonzentration im Bereich c des Wannengebiets 20 insgesamt niedriger ist als im übrigen Bereich des Wannengebiets 20 stellt sich damit in den beiden Teilgebieten 38 und 44 des Drainextension-Gebiets eine gegenüber dem übrigen Teil des Drainextension-Gebiets 24 erhöhte Konzentration an elektrisch aktiven Dotierstoffen ein. Dies führt zu einer verbesserten elektrischen Leitfähigkeit in dem von den beiden Teilgebieten 44 und 38 repräsentierten, sich an den Kanal unterhalb des Gate 32 anschließenden Bereich des Drainextension-Gebiets 24. Somit verringert sich der Einschaltwiderstand des PMOS-Transistors, der wegen des Feldoxidstegs 37 über eine erhöhte Spannungsfestigkeit verfügt. Die Dotierstoffkonzentrationsprofile entlang der Linien 4 bis 7 der Fig. 3 sind in den Fign. 5 und 6 wiedergegeben. Mit den Buchstaben e bis k sind jeweils die sich zwischen unterschiedlich dotierten Bereichen ergebenden pn-Übergänge gekennzeichnet.

Zusätzlich kann bei dem Transistor gemäß Fig. 3 noch eine Schwellenspannungs-Ionenimplantation unterhalb des Gate 32 in das Substrat 10 eingebracht sein. Diese Implantation ist zweckmäßigerweise im Übergangsbereich zwischen der Gate-Oxidschicht 36 und dem Feldoxidsteg 37 ausmaskiert. Diese Schwellenspannungs-Implantation dient der Einstellung der Schwellenspannung des Transistors und ist zweckmäßigerweise auch in der übrigen freiliegenden Oberseite des Drainextension-Gebiets 24, also insbesondere im Bereich 38 eingebracht, um auch hier nochmals zur Erhöhung der Leitfähigkeit zu sorgen.

## Patentansprüche

1. MOS-Transistor mit hoher Spannungfestigkeit und geringem Einschaltwiderstand mit
- einem Substrat (10), das eine Dotierung eines ersten Leitungstyps aufweist,
- einem in dem Substrat (10) ausgebildeten Wannengebiet (20), das eine Dotierung eines dem ersten Leitungstyp entgegengesetzten zweiten Leitungstyp aufweist,
- in dem Wannengebiet (20) ausgebildeten Source- und Drain-Gebieten (26,28) vom ersten Leitungstyp,
- einem eine Gate-Oxidschicht (36) aufweisenden Gate (32) zwischen dem Source-Gebiet (26) und dem Drain-Gebiet (28), wobei das Gate (32) einen drainseitigen Endbereich (42) aufweist, der von dem Drain-Gebiet (28) beabstandet ist (40), und wobei unterhalb des drainseitigen Endbereichs (42) des Gate (32) ein Feldoxidsteg (37) angeordnet ist, und
- einem Drainextension-Gebiet (24), das eine Dotierung vom ersten Leitungstyp aufweist und innerhalb dessen das Drain-Gebiet (28) ausgebildet ist, wobei das Drainextension-Gebiet (24) bis unterhalb der Gate-Oxidschicht (36) des Gate (32) reicht,
**dadurch gekennzeichnet ,**
- **dass** das Drainextension-Gebiet (24) mit implantierten Ionen versehen ist und einen ersten Teilbereich (44), der unterhalb des Feldoxidsteges (37) angeordnet ist, und einen sich in Richtung auf das Drain-Gebiet (28) an den ersten Teilbereich (44) anschließenden zweiten Teilbereich (38) aufweist, innerhalb dessen zumindest ein Teilbereich des Drain-Gebiets (28) angeordnet ist oder an das das Drain-Gebiet (28) angrenzt, wobei die Konzentration an elektrisch aktiver Dotierung vom ersten Leitungstyp im ersten Teilbereich (44) des Drainextension-Gebiets (24) kleiner ist als im zweiten Teilbereich (38) des Drainextension-Gebiets (24), jedoch größer als im übrigen Bereich des Drainextension-Gebiets (24) ist, und
- **dass** das Wannengebiet (20) thermisch induziert diffundierte Ionen aufweist, die in zwei um einen mit den ersten und den zweiten Teilgebieten (44,38) des Drainextension-Gebiets (24) ausgerichteten Abstandsbereich (14) voneinander beabstandeten Teilbereiche (16,18) implantiert sind, wobei diese beiden Teilbereiche (16,18) innerhalb eines dem ersten und dem zweiten Teilgebiet (44,38) des Drainextension-Gebiets (24) entsprechenden Verbindungsbereichs (c) untereinander verbunden sind und in diesem Verbindungsbereich (c)
- (i) die Konzentration an Dotierung vom zweiten Leitungstyp niedriger als im übrigen Bereich des Wannengebiets (20) sowie
- (ii) das Wannengebiet (20) weniger tief als in seinem übrigen Bereich
ist.

2. MOS-Transistor nach Anspruch 1, **dadurch gekennzeichnet, dass** sich unterhalb des Gate (32) mit Ausnahme des Übergangsbereichs zwischen der Gate-Oxidschicht (36) und dem Feldoxidsteg (38) der Einstellung der Schwellenspannung dienende Ionen befinden.

3. MOS-Transistor nach Anspruch 2, **dadurch gekennzeichnet, dass** die der Einstellung der Schwellenspannung dienenden Ionen sich auch in dem Drainextension-Gebiet (24) befinden.

4. MOS-Transistor nach einem der Ansprüche 1 bis 3, **dadurch gekennzeichnet, dass** die Dotierung vom ersten Leitungstyp eine p-Dotierung und die Dotierung vom zweiten Leitungstyp eine n-Dotierung ist.

## Claims

1. MOS transistor with high voltage-sustaining capability and low closing resistance, comprising:
- a substrate (10) comprising a doping of a first conductive type,
- a well area (20) formed in the substrate (10) and provided with a doping of a second conductive type opposite to the first conductive type,
- source and drain areas (26,28) of the first conductive type formed in the well area (20),
- a gate (32) comprising a gate oxide layer (36) and arranged between the source area (26) and the drain area (28), the gate (32) having a drain-side end region (42) arranged at a distance (40) to the drain area (28), and a field oxide web (37) arranged below the drain-side end region (42) of the gate (32), and
- a drain extension region (24) comprising a doping of the first conductive type and having the drain area (28) arranged therein, the drain extension region (24) extending below the gate oxide layer (36) of the gate (32),
**characterized in that**
- the drain extension region (24) is formed by ion implantation and comprises a first partial area (44) arranged below the field oxide web (37) and a second partial area (38) joining the first partial area (44) in the direction of the drain area (28) and having at least a partial area of the drain area (28) arranged therein or having the drain area (28) bordering thereon, the concentration of the electrically active doping of the first conductive type being smaller in the first partial area (44) of the drain extension region (24) than in the second partial area (38) of the drain extension region (24), but larger than in the remaining region of the drain extension region (24), and
- the well area (20) comprises thermally inducedly diffused ions implanted into two partial areas (16,18) spaced from each other by a distance region (14) aligned with the first and the second partial area (44, 38) of the drain extension region (24), wherein these two partial areas (16,18) are connected to each other within a connection region (c) corresponding to the first and the second partial area (44,38) of the drain extension region (24), and in this connection region (c)
- (i) the concentration of the doping of the second conductive type is lower than in the remaining well area (20), and
- (ii) the well area (20) is less deep than in its remaining area.

2. MOS transistor according to claim 1, **characterized in that** below the gate (32), except for the transition region between the gate oxide layer (36) and the field oxide web (38), ions for setting the threshold voltage are located.

3. MOS transistor according to claim 2, **characterized in that** the ions for setting the threshold voltage are also located in the drain extension region (24).

4. MOS transistor according to one of claims 1 to 3, **characterized in that** the doping of the first conductive type is a p-doping and the doping of the second conductive type is an n-doping.

## Revendications

1. Transistor MOS comportant une résistance diélectrique élevée et une faible résistance de conduction, et comportant
- un substrat (10), qui possède un dopage ayant un premier type de conductivité,
- une région en forme de cuvette (1) formée dans le substrat (10) et qui possède un dopage ayant un second type de conductivité opposé au premier type de conductivité,
- des régions de source et de drain (26,28) formées dans la région en forme de cuvette (20) et possédant le premier type de conductivité,
- une grille (32) possédant une couche d'oxyde de grille (36) et disposée entre la région de source (26) et la région de drain (28), la grille (32) possédant une partie d'extrémité (42) située du côté du drain et qui est distante (40) de la région de drain (28), une barrette d'oxyde de champ (37) étant disposée au-dessous de la partie d'extrémité (42), située du côté du drain, de la grille (32), et
- une région d'extension de drain (24), qui possède un dopage possédant le premier type de conductivité et à l'intérieur de laquelle est disposée la région de drain (28), la région d'extension de drain (24) s'étendant jusqu'au-dessous de la couche d'oxyde de grille (36) de la grille (32),
**caractérisé en ce**
- **que** la région d'extension de drain (24) est pourvue d'ions implantés et comporte une première région partielle (44), qui est disposée au-dessous de la barrette d'oxyde de champ (37), et une seconde région partielle (38), qui se raccorde à la première région partielle (44) en direction de la région de drain (28) et à l'intérieur de laquelle est disposée au moins une région partielle de la région de drain (28), ou jouxte la région de drain (28), la concentration de dopage actif électriquement possédant le premier type de conductivité étant plus petite dans la première région partielle (44) de la région d'extension de drain (24) que dans la seconde région partielle (38) de la région d'extension de drain (24), mais plus élevée dans le reste de la région d'extension de drain (24), et
- **que** la région en forme de cuvette (20) comporte des ions introduits par diffusion d'une manière induite thermiquement et qui sont implantés dans deux régions partielles (16,18) séparées l'une de l'autre par une zone de séparation (14) alignées avec les première et seconde régions partielles (44,38) de la région d'extension de drain (24), ces deux régions partielles (16,18) étant reliées entre elles à l'intérieur d'une région de liaison (c) qui correspond aux première et seconde régions partielles (44,38) de la région d'extension de drain (24), et dans cette région de liaison (c)
- (i) la concentration de dopage avec le second type de conductivité étant plus faible que dans le reste de la région en forme de cuvette (20), et
- (ii) la région en forme de cuvette (20) étant moins profonde que dans la région restante.

2. Transistor MOS selon la revendication 1, **caractérisé en ce que** des ions utilisés pour le réglage de la tension de seuil sont situés au-dessous de la grille (32) à l'exception de la zone de jonction entre la couche d'oxyde de grille (36) et la barrette d'oxyde de champ (38).

3. Transistor MOS selon la revendication 2, **caractérisé en ce que** les ions utilisés pour le réglage de la tension de seuil, sont situés également dans la région d'extension de drain (24).

4. Transistor MOS selon l'une des revendications 1 à 3, **caractérisé en ce que** le dopage avec le premier type de conductivité est un dopage de type p et le dopage avec le second type de conductivité est un dopage de type n.
